# EUROPÄISCHE PATENTSCHRIFT

(11) **EP 2 324 088 B1**
(45) Veröffentlichungstag und Bekanntmachung des Hinweises auf die Patenterteilung: **03.12.2014**
(21) Anmeldenummer: 09782197.9
(22) Anmeldetag: 26.08.2009
(51) Int. Cl.: C09J 7/00, C09J 177/06

(54) **HITZEAKTIVIERBARES KLEBEBAND INSBESONDERE FÜR DIE VERKLEBUNG VON ELEKTRONISCHEN BAUTEILEN UND LEITERBAHNEN**
HEAT-ACTIVATABLE ADHESIVE TAPE, IN PARTICULAR FOR THE ADHESIVE BONDING OF ELECTRONIC COMPONENTS AND CONDUCTOR TRACKS
RUBAN ADHÉSIF THERMOACTIVABLE, EN PARTICULIER POUR LE COLLAGE DE COMPOSANTS ÉLECTRONIQUES ET DE PISTES CONDUCTRICES

(30) Priorität: 11.09.2008 DE 102008046873
(43) Veröffentlichungstag der Anmeldung: 25.05.2011
(73) Patentinhaber: TESA SE, 20253 Hamburg (DE)
(72) Erfinder: KRAWINKEL, Thorsten, 22457 Hamburg (DE); LORENZ, Marcel, 06888 Mühlanger (DE)
(86) Internationale Anmeldenummer: PCT/EP2009/060976
(87) Internationale Veröffentlichungsnummer: WO 2010/028948

(56) Entgegenhaltungen:
- EP-A1- 0 441 545
- WO-A1-2008/043662
- US-A- 5 605 944

## Beschreibung

Die Erfindung betrifft eine hitzeaktivierbare Klebmasse mit geringem Fließvermögen bei hohen Temperaturen insbesondere zur Verklebung von flexiblen gedruckten Leiterbahnen (auch flexible gedruckte Schaltungen, Flexible Printed Circuit Boards, FPCBs genannt).

Flexible Printed Circuit Boards werden heutzutage in einer Vielzahl von elektronischen Geräten wie Handys, Radios, Computern, Druckern und vielen anderen eingesetzt. Sie sind aufgebaut aus Schichten von Kupfer und einem hochschmelzenden widerstandsfähigen Thermoplasten, meistens Polyimid, seltener Polyester. Für die Herstellung dieser FPCBs werden häufig Klebebänder mit besonders hohen Ansprüchen eingesetzt. Zum einen werden zur Herstellung der FPCBs die Kupferfolien mit den Polyimidfolien verklebt, zum anderen werden auch einzelne FPCBs miteinander verklebt, in diesem Fall findet eine Verklebung von Polyimid auf Polyimid statt. Daneben werden die FPCBs auch auf andere Substrate geklebt.

An die Klebebänder, die für diese Verklebungen eingesetzt werden, werden sehr hohe Ansprüche gestellt. Da sehr hohe Verklebungsleistungen erreicht werden müssen, werden im Allgemeinen hitzeaktivierbare Klebebänder eingesetzt, die bei hohen Temperaturen verarbeitet werden. Diese Klebebänder dürfen während dieser hohen Temperaturbelastung bei der Verklebung der FPCBs, die häufig bei Temperaturen um 200 °C stattfindet, keine flüchtigen Bestandteile abgeben. Um eine hohe Kohäsion zu erreichen, sollten die Klebebänder während dieser Temperaturbelastung vernetzen. Hohe Drücke während des Verklebungsprozesses machen es nötig, dass die Klebebänder bei hohen Temperaturen nur eine geringe Fließfähigkeit besitzen. Dieses wird durch hohe Viskosität des unvernetzten Klebebandes oder durch eine sehr schnelle Vernetzung erreicht. Zudem müssen die Klebebänder noch lötbadbeständig sein, das heißt, für eine kurze Zeit eine Temperaturbelastung von 288 °C überstehen.

Aus diesem Grund ist der Einsatz von reinen Thermoplasten nicht sinnvoll, obwohl diese sehr leicht aufschmelzen, für eine gute Benetzung der zu verklebenden Substrate sorgen und zu einer sehr schnellen Verklebung innerhalb von wenigen Sekunden führen. Andererseits sind diese bei hohen Temperaturen so weich, dass sie bei Verklebung unter Druck zum Herausquellen aus der Klebfuge neigen. Damit ist auch keine Lötbadbeständigkeit gegeben.

Üblicherweise werden für vernetzbare Klebebänder Epoxidharze oder Phenolharze eingesetzt, die mit bestimmten Härtern zu polymeren Netzwerken reagieren. In diesem speziellen Fall sind die Phenolharze nicht einsetzbar, da sie bei der Vernetzung Abspaltprodukte erzeugen, die freigesetzt werden und während der Aushärtung oder spätestens im Lötbad zu einer Blasenbildung führen.

Epoxidharze werden hauptsächlich in der Konstruktionsverklebung eingesetzt und ergeben nach der Aushärtung mit entsprechenden Vernetzern sehr spröde Klebmassen, die zwar hohe Klebfestigkeiten erreichen, aber kaum flexibel sind.

Eine Steigerung der Flexibilität ist für den Einsatz in FPCBs unumgänglich. Zum einen soll die Verklebung mit Hilfe eines Klebebandes geschehen, das idealerweise auf eine Rolle gewickelt ist, zum anderen handelt es sich um flexible Leiterbahnen, die auch gebogen werden müssen, gut zu erkennen am Beispiel der Leiterbahnen in einem Laptop, bei dem der aufklappbare Bildschirm über FPCBs mit den weiteren Schaltungen verbunden ist.

Eine Flexibilisierung dieser Epoxidharzkleber ist auf zwei Arten möglich. Zum einen existieren mit Elastomerketten flexibilisierte Epoxidharze, die aber durch die sehr kurzen Elastomerketten nur eine begrenzte Flexibilisierung erfahren. Die andere Möglichkeit ist, die Flexibilisierung durch die Zugabe von Elastomeren zu erreichen, die der Klebmasse zugegeben werden. Diese Variante hat den Nachteil, dass die Elastomere chemisch nicht vernetzt werden, wodurch nur solche Elastomere zum Einsatz kommen können, die bei hohen Temperaturen immer noch eine hohe Viskosität aufweisen.

Da die Klebebänder meistens aus Lösung hergestellt werden, ist es häufig schwierig, Elastomere zu finden, die langkettig genug sind, um bei hohen Temperaturen nicht zu fließen, andererseits aber noch so kurzkettig sind, dass sie in Lösung gebracht werden können.

Eine Herstellung über einen Hotmelt-Prozess ist bei vernetzenden Systemen nur sehr schwierig möglich, da eine frühzeitige Vernetzung während des Herstellprozesses vermieden werden muss.

Der Einsatz von Polyamiden, die durch Epoxidharze vernetzbar sind, führt zu sehr kohäsiven Klebmassen mit zum Teil hoher Verklebungsfestigkeit. Problematisch ist, dass sich die meisten Polyamide nicht in typischen organischen Lösungsmitteln lösen lassen, häufig sind Lösungsmittel wie Dimethylformamid nötig mit solch einem hohen Siedepunkt, dass ein Trocknen der Materialien nach dem Ausstreichen sehr aufwendig ist.

Vernetzbare Klebmassen auf der Basis von Polyamid oder deren Derivaten sind beschrieben.

Dabei handelt es sich wie in US 5,885,723 A oder JP 10 183074 A beziehungsweise JP 10 183 073 A um modifizierte Polyamide, die bevorzugt Polycarbonat- oder Polyalkylenglycolgruppen enthalten. Die Polyamide werden dabei so umgesetzt, dass sie Epoxidendgruppen enthalten und dadurch mit den Epoxiden durch einen Härter vernetzt werden können.

Ansonsten werden Klebmassen mit Polyamidimiden sehr spezieller Zusammensetzung zum Beispiel in der US 6,121,553 A offenbart.

In der WO 0001782 A1 werden Klebmassen auch auf Basis von Polyamiden und vernetzenden Harzen beschrieben. Allerdings reagieren in diesen Klebmassen die Epoxidharze mit einem Härter und bilden so ein dreidimensionales Netzwerk, das Polyamid dient nur als Flexibilisierungsmittel.

Die Schrift WO 2008/043662 A1 beschreibt ein hitzeaktivierbares Klebeband für die Herstellung und Weiterverarbeitung von elektronischen Bauteilen mit einer Klebemasse, die ein Polyamid mit Säure- oder Aminoendgruppen und eine epoxidgruppenhaltige Verbindung aufweist, die miteinander reagieren können. Polyamide mit cyclischen Bestandteilen sind in dieser Schrift nicht genannt.

Aufgabe der Erfindung war es somit, ein Klebeband bereitzustellen, dass hitzeaktivierbar ist, in der Hitze vernetzt, eine geringe Viskosität in der Hitze besitzt, gute Haftung auf Polyimid zeigt und im unvernetzten Zustand löslich in organischen Lösungsmitteln ist.

Gelöst wird diese Aufgabe überraschend durch ein Klebeband, wie es in dem Hauptanspruch näher gekennzeichnet ist. Gegenstand der Unteransprüche sind vorteilhafte Weiterentwicklungen des Erfindungsgegenstandes sowie Verwendungsmöglichkeiten desselben.

Demgemäß ist Gegenstand der Erfindung ein hitzeaktivierbares Klebeband insbesondere für die Herstellung und Weiterverarbeitung von elektronischen Bauteilen und Leiterbahnen, das
- aus einem flexiblen Substrat, das mit einer Releaseschicht versehen ist, und
- einer Schicht einer Klebemasse
besteht, wobei die Klebemasse zumindest
a) ein Polyamid, das löslich in Ethanol, Toluol oder deren Gemischen ist und gebildet wird aus zumindest aus einem heterocyclischen Diamin der folgenden Formel 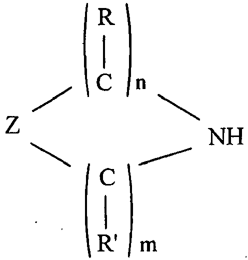 wobei
   - Z eine NH-Gruppe ist oder eine aliphatische Kette mit einer NH₂-Gruppe am Ende,
   - n und m jeweils unabhängig voneinander eine ganze Zahl zwischen 1 und 3 sind
   - die Reste R und R' an jedem Kohlenstoffatom im Ring unabhängig voneinander ein Wasserstoffatom oder eine aliphatische Alkylkette sind,
   und ein
   aliphatischen Dicarbonsäure mit mindestens 4 Kohlenstoffatomen
b) eine epoxidgruppenhaltigen Verbindung,
umfasst,
wobei das Polyamid bei Temperaturen von mindestens 150 °C mit dem Epoxidharz reagiert und das Verhältnis in Gewichtsanteilen von a) und b) zwischen 50 : 50 bis 99 : 1 liegt.

In einer günstigen Ausbildungsform besteht die Klebemassenschicht des hitzeaktivierbaren Klebebandes aus den vorgenannten Komponenten a) und b), es ist aber im erfindungsgemäßen Sinne auch möglich, dass die Klebemassenschicht des hitzeaktivierbaren Klebebandes weitere Komponenten umfasst.

Der allgemeine Ausdruck Klebeband umfasst im Sinne dieser Erfindung alle flächigen Gebilde wie in zwei Dimensionen ausgedehnte Folien oder Folienabschnitte, Bänder mit ausgedehnter Länge und begrenzter Breite, Bandabschnitte, Stanzlinge und dergleichen.

Vorzugsweise liegt das Verhältnis in Gewichtsanteilen von a) und b) zwischen 70 : 30 bis 95 : 5.

Die in den erfindungsgemäßen Klebmassen eingesetzten Polyamide sollten ein nicht zu hohes Molekulargewicht (vorzugsweise ein gewichtsmittleres Molekulargewichte M_{w} kleiner 40000 g/mol) aufweisen und flexibilisiert beziehungsweise nur zum Teil oder gar nicht kristallin sein. Dieses ist zum einen für die beschriebene Flexibilität der Klebmassen erforderlich, zum anderen werden die Rohstoffe vorzugsweise aus der Lösung verarbeitet und vollständig kristalline Polyamide lassen sich nur schwer und in nicht konvenienten Lösungsmitteln wie Trifluoressigsäure oder Schwefelsäure lösen.

Deshalb werden gemäß einer vorteilhaften Weiterführung der Erfindung zwei unterschiedliche lange Dicarbonsäuren als Monomere eingesetzt, z.B. Undecan- und Dodecandisäure.

Um die Kristallinität weiter zu senken, ist auch der Einsatz von Polymergemischen möglich.

Wichtig für die Synthese der Polyamide ist, dass entweder die Aminokomponente(n) oder die Säurekomponente(n) in einem Überschuss verwendet werden, damit zum einen das Molekulargewicht nicht zu hoch wird, zum anderen, damit endständige reaktive Gruppen vorhanden sind, die mit den Epoxidharzen reagieren können.

Da die Polyamide vernetzt werden, ist es auch möglich, recht niedermolekulare Oligomere (nämlich solche mit einem gewichtsmittleren Molekulargewichte M_{w} von 500 bis 2000 g/mol) einzusetzen, um eine ausreichende Festigkeit zu erhalten.

Besonders geeignet sind Polyamide die zumindest als eine Komponente ein Diamin vorstehender Formel enthalten, bei dem Z eine NH-Gruppe und n und m jeweils 2 sind.

Besonders bevorzugt sind solche Polyamide bei denen zumindest eine DiaminoKomponente Piperazin ist.

Neben aliphatischen Dicarbonsäuren und den beschriebenen Diaminen können auch Säureamide, bzw. Lactame zum Einsatz kommen.

Beispiele für einsetzbare Polyamide sind die Platamide der Fa. Arkema.

Als Epoxidharze werden üblicherweise sowohl monomere als auch oligomere Verbindungen mit mehr als einer Epoxidgruppe pro Molekül verstanden. Diese können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze, gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden, sind verwendbar. Ebenfalls sind elastisch modifizierte Epoxidharze einsetzbar.

Die folgenden Verbindungen lassen sich erfindungsgemäß vorteilhaft einsetzen:
Beispiele von Epoxidharzen sind Araldite™ 6010, CY-281™, ECN™ 1273, ECN™ 1280, MY 720, RD-2 von Ciba Geigy, DER™ 331, 732, 736, DEN™ 432 von Dow Chemicals, Epon ™ 812, 825, 826, 828, 830 etc. von Shell Chemicals, HPT™ 1071, 1079 ebenfalls von Shell Chemicals, Bakelite™ EPR 161, 166, 172, 191, 194 etc. der Bakelite AG.

Kommerzielle aliphatische Epoxidharze sind zum Beispiel Vinylcyclohexandioxide wie ERL-4206, 4221, 4201, 4289 oder 0400 von Union Carbide Corp.

Elastifizierte Elastomere sind erhältlich von der Firma Noveon unter dem Namen Hycar. Epoxidverdünner, monomere Verbindungen mit mehreren Epoxidgruppen sind zum Beispiel Bakelite™ EPD KR, EPD Z8, EPD HO, EPD WF, etc. der Bakelite AG oder Polypox™ R 9, R 12, R 15, R 19, R 20 etc. der Firma UCCP.

Gemäß einer bevorzugten Ausführungsform der Erfindung werden mehr als ein Epoxidharz gleichzeitig eingesetzt.

Durch die hohe Festigkeit der Polyamide und die zusätzliche Vernetzung mit den Epoxidharzen werden sehr große Festigkeiten innerhalb des Klebefilms erreicht. Aber auch die Verklebungsfestigkeiten zum Polyimid sind ausgesprochen hoch.

Idealerweise werden die Epoxidharze und die Polyamide in einem Mengenverhältnis eingesetzt, dass der molare Anteil an Epoxidgruppen und Aminogruppen beziehungsweise Säuregruppen gerade äquivalent ist.

Das Verhältnis zwischen Härtergruppen und Epoxidgruppen kann aber in weiten Bereichen variiert werden, dabei sollte für eine ausreichende Vernetzung keine der beiden Gruppen in mehr als einem zehnfachen moläquivalenten Überschuss vorliegen.

Zur zusätzlichen Vernetzung ist es auch möglich, chemische Vernetzer zuzusetzen, die mit den Epoxidharzen reagieren. Vernetzer sind für die Reaktion nicht nötig, können aber besonders, um einen Überschuss an Epoxidharz abzufangen, zugegeben werden.

Als Vernetzer beziehungsweise Härter kommen hauptsächlich folgende Verbindungen zum Einsatz, wie sie in der US 3,970,608 A näher beschrieben sind:
- Mehrwertige aliphatische Amine wie zum Beispiel Triethylentetramin
- Mehrwertige aromatische Amine wie zum Beispiellsophorondiamin
- Guanidine wie zum Beispiel Dicyandiamid
- Mehrwertige Phenole
- Mehrwertige Alkohole
- Mehrwertige Mercaptane
- Mehrwertige Carbonsäuren
- Säureanhydride mit einer oder mehreren Anhydridgruppen

Vorteil dieser Klebebänder auf der Basis von den beschriebenen Polyamiden und Epoxidharz mit und ohne Härter ist die hohe Halteleistung.

Üblicherweise sollte der Erweichungspunkt dieser Klebmassen nicht über 130°C liegen, da die Klebebänder vor einer Verpressung auf den zu verklebenden Gegenstand heiß laminiert werden. Üblicherweise ist die Laminiertemperatur bei diesen Klebmassen niedriger. Um diese Temperatur weiter herabzusetzen, können den Klebmassen Weichmacher zugesetzt werden. Neben der Laminiertemperatur kann durch die Zugabe von Weichmachern auch die Vernetzungstemperatur gesenkt werden, gleichzeitig wird die Lagerungsstabilität erhöht.

Als Weichmacher kommen zum einen die typischerweise in PVC eingesetzten Weichmacher in Frage.

Diese können zum Beispiel gewählt werden aus den Gruppen der
- Phthalate wie DEHP (Diethylhexylphthalat), DBP (Dibutylphthalat), BBzP (Butylbenzylphthalat), DnOP (Di-n-octylphthalat), DiNP (Di-iso-nonylphthalat), DiDP (Di-iso-decylphthalat)
- Trimellitate wie TOTM (Trioctyltrimellitat), TINTM (Triisononyltrimellitat)
- Aliphatische Dicabonsäureester wie DOM (Dioctylmaleat), DOA (Dioctyladipat), DINA (Diisononyladipat)
- Phosphorsäureester wie TCEP (Tris(2-chlorethyl)phosphat)
- natürlichen Öle wie Rizinusöl oder Campher

Zudem sind auch folgende Weichmacher einsetzbar:
- niedermolekulare- Polyalkylenoxide, wie Polyethylenoxide, Polypropylenoxide und PolyTHF (Polytetrahydrofuran)
- Klebharze auf der Basis von Kolophonium, wie beispielsweise Foralyn 5040 oder Foral 85 der Firma Eastman

Bevorzugt sind dabei die letzten beiden Gruppen wegen ihrer besseren Umweltverträglichkeit und der geringeren Neigung, aus dem Klebmassenverbund hinauszudiffundieren.

Auch Mischungen der einzelnen Weichmacher sind einsetzbar.

Um die Reaktionsgeschwindigkeit der Vernetzungsreaktion zu erhöhen, ist der Einsatz von so genannten Beschleunigern möglich.

Beschleuniger können zum Beispiel sein:
- tertiäre Amine wie Benzyldimethylamin, Dimethylaminomethylphenol,
- Tris(dimethylaminomethyl)phenol
- Bortrihalogenid-Amin-Komplexe
- substituierte Imidazole
- Triphenylphosphin

Als weitere Additive können typischerweise genutzt werden:
- primäre Antioxidanzien wie zum Beispiel sterisch gehinderte Phenole
- sekundäre Antioxidanzien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine Verarbeitungshilfsmittel
- Füllstoffe wie zum Beispiel Siliziumdioxid, Glas (gemahlen oder in Form von Kugeln), Aluminiumoxide, Zinkoxide, Calciumcarbonate, Titandioxide, Ruße, Metallpulver, etc.
- Farbpigmente und Farbstoffe sowie optische Aufheller.

Zur Herstellung des Klebebandes werden die Bestandteile der Klebmasse in einem geeigneten Lösungsmittel, zum Beispiel Ethanol, Methanol, Toluol, oder einem Gemisch aus diesen gelöst und auf ein flexibles Substrat, das mit einer Releaseschicht versehen ist, zum Beispiel einem Trennpapier oder einer Trennfolie beschichtet und getrocknet, so dass die Masse von dem Substrat leicht wieder entfernt werden kann. Nach entsprechender Konfektionierung können Stanzlinge, Rollen oder sonstige Formkörper bei Raumtemperatur hergestellt werden. Entsprechende Formkörper werden dann vorzugsweise bei erhöhter Temperatur auf das zu verklebende Substrat, zum Beispiel Polyimid, aufgeklebt.

Es ist nicht erforderlich, dass die Verklebung als einstufiges Verfahren erfolgt, sondern auf eines der beiden Substrate kann zunächst das Klebeband geheftet werden, indem man in der Wärme laminiert. Beim eigentlichen Heißklebeprozess mit dem zweiten Substrat (zweite Polyimidfolie oder Kupferfolie) härten die Epoxidgruppen dann ganz oder teilweise aus, und die Klebstofffuge erreicht die hohe Verklebungsfestigkeit.

Die zugemischten Epoxidharze und die Polyamide sollten vorzugsweise bei der Laminiertemperatur noch keine chemische Reaktion eingehen, sondern erst bei der Heißverklebung miteinander reagieren.

Die hergestellten Klebmassen haben gegenüber vielen gebräuchlichen Klebmassen zur Verklebung von FPCBs den Vorteil, nach der Verklebung eine sehr hohe Temperaturstabilität zu besitzen, so dass der geschaffene Verbund auch noch bei Temperaturen von über 150°C sehr fest ist.

Vorteil der erfindungsgemäßen Klebmassen ist, dass das Elastomer tatsächlich chemisch mit dem Harz vernetzt, eine Zugabe eines Härters für das Epoxidharz ist nicht notwendig, da das Elastomer selbst als Härter wirkt.

Dabei kann die Vernetzung sowohl über endständige Säuregruppen als auch über endständige Aminogruppen stattfinden. Auch eine Vernetzung über beide Mechanismen gleichzeitig ist möglich. Damit genügend Endgruppen vorhanden sind, darf das Molekulargewicht der Polyamide nicht zu hoch sein, da ansonsten der Vernetzungsgrad zu gering wird. Molekulargewichte über 40.000 führen zu nur wenig vernetzten Produkten.

Die Molekulargewichtsbestimmungen der gewichtsmittleren Molekulargewichte M_{w} erfolgten mittels Gelpermeationschromatographie (GPC). Als Eluent wurde THF (Tetrahydrofuran) mit 0,1 Vol.-% Trifluoressigsäure eingesetzt. Die Messung erfolgte bei 25 °C. Als Vorsäule wurde PSS-SDV, 5 µ, 10³ Å, ID 8,0 mm x 50 mm verwendet. Zur Auftrennung wurden die Säulen PSS-SDV, 5 µ, 10³ sowie 10⁵ und 10⁶ Å mit jeweils ID 8,0 mm x 300 mm eingesetzt. Die Probenkonzentration betrug 4 g/l, die Durchflussmenge 1,0 ml pro Minute. Es wurde gegen PMMA-Standards gemessen.

### Beispiele

Im Folgenden wird die Erfindung durch einige Beispiele näher beschrieben, ohne dabei die Erfindung in irgendeiner Weise zu beschränken.

### Beispiel 1

90 Teile eines Copolyamids aus Piperazin und Undecan- bzw. Dodecandisäure mit Aminoendgruppen und 10 Gew.-% eines festes Epoxidharzes auf Basis Bisphenol A werden in einer Mischung aus Toluol und Ethanol (1 :1) gelöst, Feststoffgehalt 30 Gew.-%.

Nach vollständiger Lösung der Komponenten wird die Lösung auf einem silikonisierten Träger ausgestrichen, so dass man nach Trocknen einen Klebefilm von 25 µm erhält.

### Beispiel 2

80 Teile eines Copolyamids aus Piperazin und Undecan- bzw. Dodecandisäure- mit Aminoendgruppen, 10% eines flüssigen aliphatischen Epoxidharzes Polypox R16 der Fa. UPPC und 10 Gew.-% eines Polyethylenglycols mit einer mittleren Molaren Masse (M_{w}) von 900 g/mol werden in einer Mischung aus Toluol und Ethanol (1 :1) gelöst, Feststoffgehalt 30 Gew.-%.

Nach vollständiger Lösung der Komponenten wird die Lösung auf einem silikonisierten Träger ausgestrichen, so dass man nach Trocknen einen Klebefilm von 25 µm erhält.

### Vergleichsbeispiel 3

90 Teile des oben beschriebenen Copolyamids, bei dem die Aminoendgruppen mit Benzoesäurechlorid umgesetzt wurden, werden wie oben beschrieben zusammen mit 10 Gew.-% des festen Epoxidharzes auf Basis Bisphenol A in Ethanol/Toluol (1 : 1) gelöst und zu einem Klebefilm der Dicke 25 µm ausgestrichen.

### Vergleichsbeispiel 4

Herstellung einer Klebmasse analog Beispiel 1, mit den Verhältnissen von Polyamid zu Epoxidharz von 40:60.

### Verklebung von FPCBs mit dem hergestellten Klebeband

Zwei FPCBs werden jeweils mit den nach den Beispielen 1 bis 3 hergestellten Klebebändern verklebt. Dazu wird das Klebeband auf die Polyimidfolie des FPCB-Laminats aus Polyimid/Kupferfolie bei 170 °C auflaminiert. Anschließend wird eine zweite Polyimidfolie eines weiteren FPCBs auf das Klebeband geklebt und der ganze Verbund in einer beheizbaren Bürklepresse bei 200 °C bei einem Druck von 1,3 MPa für eine Stunde verpresst.

Zwei FPCBs werden jeweils mit den nach den Beispielen 4 bis 7 hergestellten Klebebändern verklebt. Dazu wurde das Klebeband auf die Polyimidfolie des FPCB-Laminats aus Polyimid/Kupferfolie bei 140 °C beziehungsweise 170 °C auflaminiert. Anschließend wird eine zweite Polyimidfolie eines weiteren FPCBs auf das Klebeband geklebt, und der ganze Verbund in einer beheizbaren Bürklepresse bei 200 °C bei einem Druck von 1,3 MPa für eine Stunde verpresst.

### Prüfmethoden

Die Eigenschaften der nach den oben genannten Beispielen hergestellten Klebstofffolien werden mit folgenden Testmethoden untersucht.

### Laminiertemperatur

Es wird die Mindesttemperatur bestimmt, bei der das Klebeband auf einen Polyimidträger auflaminiert werden kann, ohne sich von selbst zu lösen.

### T-Peel-Test mit FPCB

Mit einer Zugprüfmaschine der Firma Zwick werden die nach dem oben beschriebenen Verfahren hergestellten Verbunde aus FPCB/Klebeband/FPCB im 180 ° Winkel mit einer Geschwindigkeit von 50 mm/min auseinander gezogen und die benötigte Kraft in N/cm gemessen. Die Messungen werden bei 20 °C und 50 % rel. Feuchte durchgeführt. Jeder Messwert wird dreifach bestimmt.

### Lötbadbeständigkeit

Die nach dem oben beschriebenen Verfahren verklebten FPCB-Verbunde werden für 10 Sekunden auf ein 288 °C heißes Lötbad gelegt. Die Verklebung wird als lötbadbeständig gewertet, wenn sich keine Luftblasen bildeten, welche die Polyimidfolie des FPCBs aufblähen lassen. Der Test wird als nicht bestanden gewertet, wenn bereits eine leichte Blasenbildung eintritt.

### Ergebnisse:

### Laminiertemperatur

Es wurde die Mindesttemperatur bestimmt, bei der die Klebmassen noch auf das zu verklebende Substrat auffließen und so stark haften, dass der silikonisierte Träger entfernt werden kann, ohne das Klebeband vom Untergrund mit abzuziehen. Die Ergebnisse zeigt die Tabelle 1.

**Tabelle 1**

| | Laminiertemperatur |
|---|---|
| Beispiel 1 | 90 °C |
| Beispiel 2 | 80 °C |
| Vergleichsbeispiel 3 | 90 °C |
| Vergleichsbeispiel 4 | Sehr spröde, kein vernünftiges Auffließen möglich |

Bei einem geringen Gehalt an Epoxidharzen liegt die Laminiertemperatur niedrig genug, um eine Vernetzung, die bei ca. 140 °C beginnt, sicher zu vermeiden.

Zur klebtechnischen Beurteilung der oben genanten Beispiele wird zunächst der T -Peel-Test durchgeführt.

Die Ergebnisse sind der nachfolgenden Tabelle 2 zu entnehmen.

### Beispiel 1

| | T-Peel Test [N/cm] |
|---|---|
| Beispiel 1 | Delamination des Kupfer-Polyimidverbundes bei ca. 17 N/cm. Kein Versagen der Verklebung mit erfindungsgemäßem Klebeband |
| Beispiel 2 | Delamination des Kupfer-Polyimidverbundes bei ca. 16 N/cm. Kein Versagen der Verklebung mit erfindungsgemäßem Klebeband |
| Vergleichsbeispiel 3 | 2,4 |
| Vergleichsbeispiel 4 | Sehr spröde, keine flexible Verklebung möglich |

Wie zu erkennen ist, konnte in den Beispielen 1 und 2 flexible Klebmassen hergestellt werden, die für die Anwendung exzellent geeignet sind und sehr hohe Verklebungsfestigkeiten aufweisen.

Wenn das Polyamid nicht mit den Epoxidharzen reagieren kann, wie in Vergleichsbeispiel 3, ergeben sich deutlich niedrigere Werte in der Klebkraft als nach einer erfolgten Reaktion.

Durch einen zu hohen Gehalt an Epoxidharz werden die Klebmassen zu spröde für die Anwendung (siehe Vergleichsbeispiel 4).

Der Lötbadtest wurde von den Beispielen 1 und 2 bestanden, während es bei Vergleichsbeispiel 3 zu starker Blasenbildung kam.

## Patentansprüche

1. Hitzeaktivierbares Klebeband, insbesondere für die Herstellung und Weiterverarbeitung von elektronischen Bauteilen und Leiterbahnen, das
- aus einem flexiblen Substrat, das mit einer Releaseschicht versehen ist, und
- einer Schicht einer Klebemasse, die zumindest
a) ein Polyamid, das löslich in Ethanol, Toluol oder deren Gemischen ist und gebildet
wird aus
zumindest aus einem heterocyclischen Diamin der folgenden Formel 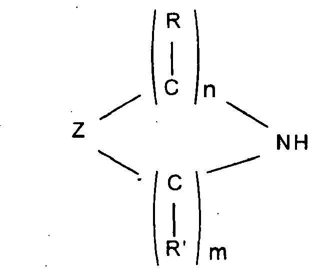 wobei
- Z eine NH-Gruppe ist oder eine aliphatische Kette mit einer NH₂-Gruppe am Ende,
- n und m jeweils unabhängig voneinander eine ganze Zahl zwischen 1 und 3 sind,
- die Reste R und R' an jedem Kohlenstoffatom im Ring unabhängig voneinander ein Wasserstoffatom oder eine aliphatische Alkylkette sind,
und einer
aliphatischen Dicarbonsäure mit mindestens 4 Kohlenstoffatomen,
und
b) eine epoxidgruppenhaltige Verbindung
umfasst,
besteht, wobei das Polyamid bei Temperaturen von mindestens 150 °C mit dem Epoxidharz reagiert und das Verhältnis in Gewichtsanteilen von a) und b) zwischen 50 : 50 bis 99 : 1 liegt.

2. Hitzeaktivierbares Klebeband nach Anspruch 1, **dadurch gekennzeichnet, dass** es sich bei dem heterocyclischen Diamin um Piperazin handelt.

3. Hitzeaktivierbares Klebeband nach Anspruch 1 oder 2, **dadurch gekennzeichnet, dass**,
das Polyamid aus zwei unterschiedlichen Disäuren mit unerschiedlich langer Alkylkette hergestellt wurde.

4. Hitzeaktivierbares Klebeband nach zumindest einem der Ansprüche 1 bis 3, **dadurch gekennzeichnet, dass**
der Klebemasse ein Weichmacher aus der aus der Gruppe Phthalate. Trimellitate Phosphorsäureester, natürliche Öle. Polyalkylenoxide, Kolophoniumharze und/oder Polyethylenglycol zugegeben ist.

5. Hitzeaktivierbares Klebeband nach zumindest einem der vorherigen Ansprüche, **dadurch gekennzeichnet dass**
das Klebeband Beschleuniger, Farbstoffe, Ruß und/oder Metallpulver enthält.

6. Verwendung eines hitzeaktivierbaren Klebebands nach zumindest einem der vorherigen Ansprüche zur Verklebung von Kunststoffteilen.

7. Verwendung eines hitzeaktivierbaren Klebebands nach zumindest einem der Ansprüche 1 bis 5 zur Verklebung von elektronischen Bauteilen und/oder von flexiblen gedruckten Schaltungen (FPCBs).

8. Verwendung eines hitzeaktivierbaren Klebebands nach zumindest einem der Ansprüche 1 bis 5 zur Verklebung auf Polyimid.

## Claims

1. Heat-activatable adhesive tape, especially for the production and onward processing of electronic components and conductor tracks, which is composed of
- a flexible substrate provided with a release layer, and
- a layer of an adhesive which comprises at least
a) a polyamide which is soluble in ethanol, toluene or mixtures thereof and is formed from at least one heterocyclic diamine of the following formula 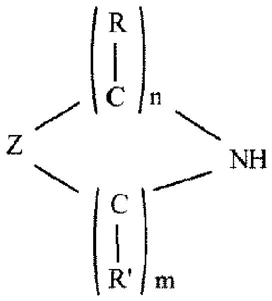 where
- Z is an NH group or an aliphatic chain with an NH₂ group at the end,
- n and m each independently of one another are an integer between 1 and 3,
- the radicals R and R' on each carbon atom in the ring independently of one another are a hydrogen atom or an aliphatic alkyl chain,
and
an aliphatic dicarboxylic acid having at least 4 carbon atoms,
and
b) a compound containing epoxide groups,
the polyamide reacting with the epoxy resin at temperatures of at least 150°C, and the ratio in weight fractions of a) and b) being between 50:50 to 99:1.

2. Heat-activatable adhesive tape according to Claim 1, **characterized in that** the heterocyclic diamine is piperazine.

3. Heat-activatable adhesive tape according to Claim 1 or 2, **characterized in that** the polyamide has been prepared from two different dibasic acids with alkyl chains of different length.

4. Heat-activatable adhesive tape according to at least one of Claims 1 to 3, **characterized in that** a plasticizer from the group consisting of phthalates, trimellitates, phosphoric esters, natural oils, polyalkylene oxides, rosins and/or polyethylene glycol is added to the adhesive.

5. Heat-activatable adhesive tape according to at least one of the preceding claims, **characterized in that** the adhesive tape comprises accelerators, dyes, carbon black and/or metal powders.

6. Use of a heat-activatable adhesive tape according to at least one of the preceding claims for the adhesive bonding of plastics parts.

7. Use of a heat-activatable adhesive tape according to at least one of Claims 1 to 5 for the adhesive bonding of electronic components and/or flexible printed circuits (FPCBs).

8. Use of a heat-activatable adhesive tape according to at least one of Claims 1 to 5 for adhesive bonding to polyimide.

## Revendications

1. Ruban adhésif activable par la chaleur, en particulier pour la fabrication et la mise en oeuvre ultérieure de composants électroniques et de pistes conductrices, qui est constitué
- d'un support flexible qui est muni d'une couche antiadhésive, et
- d'une couche d'une matière adhésive qui comprend au moins
a) un polyamide qui est soluble dans l'éthanol, le toluène ou des mélanges de ceux-ci et est formé à partir d'au moins une diamine hétérocyclique de formule suivante 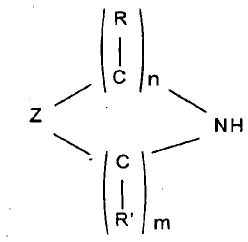 dans laquelle
- Z est un groupe NH ou une chaîne aliphatique comportant un groupe NH₂ à l'extrémité,
- n et m représentent chacun indépendamment l'un de l'autre un nombre entier compris entre 1 et 3,
- les radicaux R et R' sur chaque atome de carbone dans le cycle représentent chacun indépendamment un atome d'hydrogène ou une chaîne alkyle aliphatique,
et d'un acide dicarboxylique aliphatique ayant au moins 4 atomes de carbone,
et
b) un composé contenant des groupes époxy,
le polyamide réagissant à des températures d'au moins 150 °C avec la résine époxy et le rapport en parties en poids de a) et b) étant compris entre 50 : 50 et 99 : 1.

2. Ruban adhésif activable par la chaleur selon la revendication 1, **caractérisé en ce que**
pour ce qui est de la diamine hétérocyclique il s'agit de pipérazine.

3. Ruban adhésif activable par la chaleur selon la revendication 1 ou 2, **caractérisé en ce que** le polyamide a été préparé à partir de deux diacides différents à chaîne alkyle de longueur différente.

4. Ruban adhésif activable par la chaleur selon au moins l'une quelconque des revendications 1 à 3, **caractérisé en ce**
**qu'**un plastifiant choisi dans le groupe des phtalates, trimellitates, esters d'acide phosphorique, huiles naturelles, polyoxyalkylènes, résines de colophane et/ou polyéthylèneglycol est ajouté à la matière adhésive.

5. Ruban adhésif activable par la chaleur selon au moins l'une quelconque des revendications précédentes, **caractérisé en ce que**
le ruban adhésif contient des accélérateurs, des colorants, du noir de carbone et/ou de la poudre métallique.

6. Utilisation d'un ruban adhésif activable par la chaleur selon au moins l'une quelconque des revendications précédentes, pour le collage d'éléments en matière plastique.

7. Utilisation d'un ruban adhésif activable par la chaleur selon au moins l'une quelconque des revendications 1 à 5, pour le collage de composants électroniques et/ou de circuits imprimés flexibles (FPCB).

8. Utilisation d'un ruban adhésif activable par la chaleur selon au moins l'une quelconque des revendications 1 à 5, pour le collage sur polyimide.
